Europäisches Patentamt

European Patent Office

Office européen des brevets

(19)

(11) Veröffentlichungsnummer : **0 339 037 B1**

(12) **EUROPÄISCHE PATENTSCHRIFT**

(45) Veröffentlichungstag der Patentschrift :
**17.02.93 Patentblatt 93/07**

(21) Anmeldenummer : **88900452.9**

(22) Anmeldetag : **24.12.87**

(86) Internationale Anmeldenummer :
**PCT/DE87/00607**

(87) Internationale Veröffentlichungsnummer :
**WO 88/06380 25.08.88 Gazette 88/19**

(51) Int. Cl.⁵ : **H03H 17/06**

(54) **NICHTREKURSIVES HALB-BAND-FILTER.**

(30) Priorität : **19.02.87 DE 3705207**

(43) Veröffentlichungstag der Anmeldung :
**02.11.89 Patentblatt 89/44**

(45) Bekanntmachung des Hinweises auf die
Patenterteilung :
**17.02.93 Patentblatt 93/07**

(84) Benannte Vertragsstaaten :
**AT CH FR GB IT LI SE**

(56) Entgegenhaltungen :
**IEEE Transactions on Acoustics, Speech, and
Signal Processing, vol. ASSP-22, No.: 4, August 1974, IEEE (New York, US) M.G.Bellanger
et al.: "Interpolation, extrapolation, and reduction of computation speed in digital filters", pages 231-235
IEEE Transactions on Acoustics, Speech, and
Signal Processing, vol. ASSP-33, No.: 5, October 1985, IEEE, (New York, US), R.Ansari:
"Elliptic filter design for a class of generalized
halfband filters", pages 1146-1150**

(73) Patentinhaber : **ANT Nachrichtentechnik
GmbH
Gerberstrasse 33
W-7150 Backnang (DE)**

(72) Erfinder : **GÖCKLER, Heinz
Elbinger Strasse 52
W-7150 Backnang (DE)**

EP 0 339 037 B1

## Beschreibung

Die Erfindung bezieht sich auf ein nichtrekursives Halb-Band-Filter. Solche Filter sind bekannt geworden durch den Aufsatz "Interpolation, Extrapolation, and Reduction of Computation Speed in Digital Filters" von Bellanger et al in IEEE Transactions on Acoustics, Speech and Signal Processing, Vol. ASSP-22, Nr. 4, Aug. 74, S. 231 ff.

Die bekannten Halb-Band-Filter verarbeiten reelle Eingangssignale zu reellen Ausgangssignalen.

Zum Stande der Technik gemäß Artikel 54(3) EPÜ für die Länder FR, GB, IT, SE gehört die europäische Patentanmeldung EP-A-0 250 926 (veröffentlicht am 7.1.88), durch die ein nichtrekursives Halb-Band-Filter bekanntgeworden ist, das die Umwandlung eines reellen Eingangssignals in ein komplexes Ausgangssignal ermöglicht, indem seine Impulsantwort auf den komplexen Träger einer Frequenz von einem 1/4 der Abtastfrequenz moduliert wird und wobei die Nullphase dieser Frequenz ganze Vielfache von $\pi/2$ beträgt, und wobei die Abtastrate halbiert wird und das weiterhin die Umwandlung eines komplexen Eingangssignals in ein reelles Ausgangssignal ermöglicht, indem seine Impulsantwort auf den komplexen Träger einer Frequenz von der Hälfte der Eingangs-Abtastrate moduliert wird und wobei die Nullphase dieser Frequenz ganze Vielfache von $\pi/2$ beträgt und wobei die Abtastfrequenz verdoppelt wird.

Der vorliegenden Erfindung lag die folgende Aufgabe zugrunde, ein nichtrekursives Halb-Band-Filter anzugeben, welches die Umwandlung eines reellen Eingangssignals in ein komplexes Ausgangssignal oder umgekehrt in wenig aufwendiger Weise ermöglicht.

Die Lösung erfolgt mit den Merkmalen des Anspruches 1, 2, 10 bzw. 11.

Das erfindungsgemäße nichtrekursive Halb-Band-Filter gestattet gemäß Ansprüche 1 und 2 die Umwandlung reeller digitaler Eingangssignale in komplexe digitale Ausgangssignale bei gleichzeitiger Verminderung der Abtastfrequenz um den Faktor 2 bzw. die Umwandlung komplexer digitaler Eingangssignale in reelle digitale Ausgangssignale bei gleichzeitiger Erhöhung der Abtastfrequenz um den Faktor 2. Das erfindungsgemäße nichtrekursive Halb-Band-Filter gemäß Ansprüche 10 und 11 gestattet die Umwandlung reeller digitaler Eingangssignale in komplexe digitale Ausgangssignale unter Beibehaltung der Abtastfrequenz bzw. die Umwandlung komplexer digitaler Eingangssignale in reelle digitale Ausgangssignale ebenfalls unter Beibehaltung der Abtastfrequenz.

Diese relativ unaufwendigen Halb-Band-Filter eignen sich damit als digitales Vorfilter oder Nachfilter für digitale Systeme zur Verarbeitung komplexer Signale und als digitale Teilfilter einer Anordnung von Antialiasing Filtern zur Bandbegrenzung unter Erfüllung des Abtasttheorems. Der Vorteil des Halb-Band-Filters liegt in der linearen Phase und in dem gleichzeitig geringen Aufwand, wobei jeweils die aufgrund des Abtasttheorems erforderliche minimal mögliche Abtastfrequenz verwendet werden kann.

Es folgt nun die Beschreibung anhand der Figuren.

Die Figur 1 zeigt das Blockschaltbild des erfindungsgemäßen Digitalfilters.

In Figur 2a bis 2c sind einige Amplitudenantworten von Halb-Band-Filtern über der Frequenz aufgetragen.

Die Figuren 3 und 4 zeigen besonders günstige Schaltungsvarianten des Halb-Band-Filters.

In Figur 5 schließlich ist das Blockschaltbild eines Halb-Band-Filters zur Verarbeitung eines komplexen Eingangssignals in ein reelles Ausgangssignal gezeichnet.

Die Figur 6 zeigt die detaillierte Schaltung des Filters nach Fig. 5, wobei diese Schaltung aus der Figur 3 durch Transposition entwickelt wurde, d.h. durch Umkehrung aller Pfeilrichtungen und den Ersatz einer Verzweigung durch einen Addierer und umgekehrt und den Ersatz eines Demultiplexers durch einen Multiplexer.

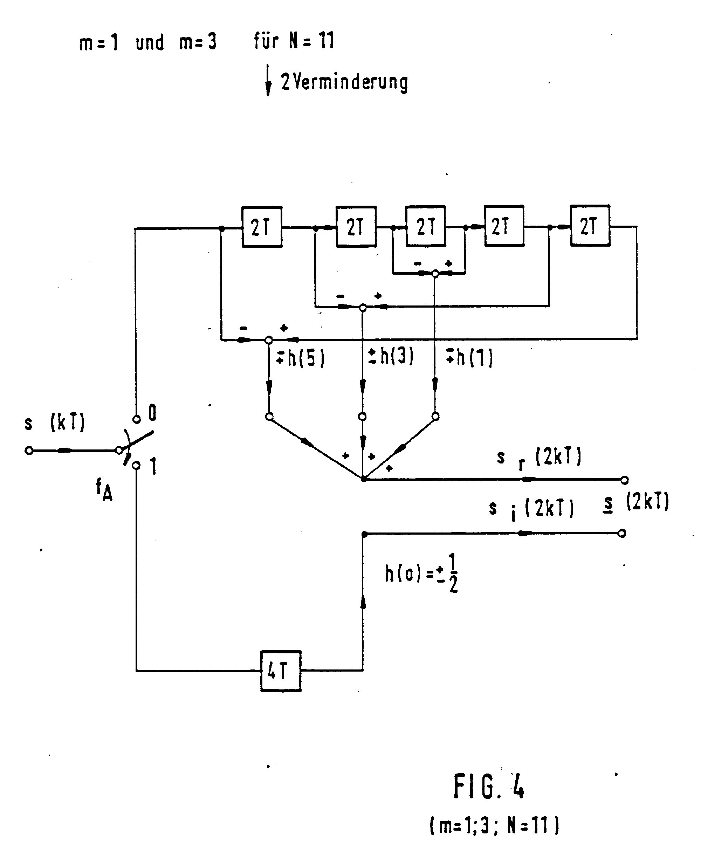

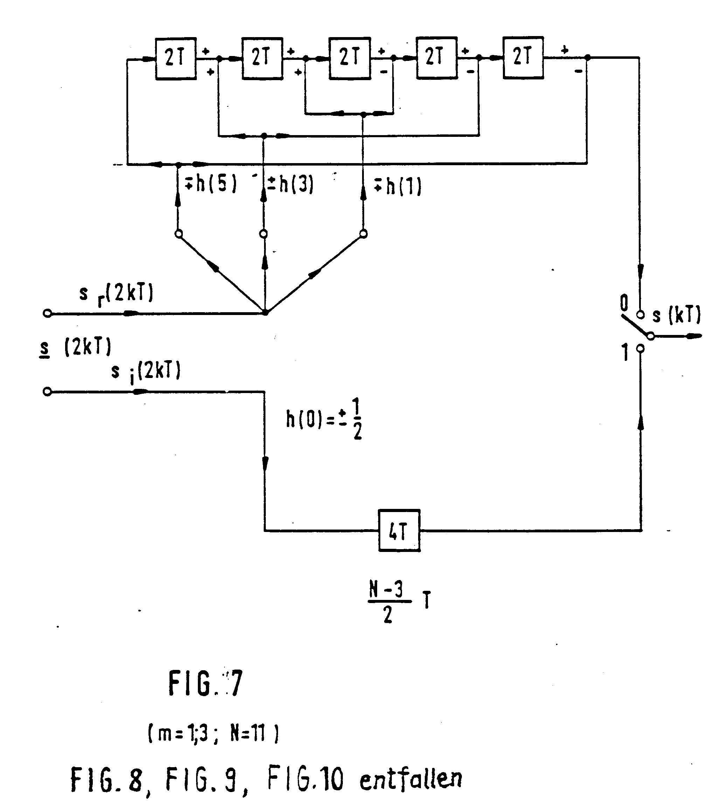

In entsprechender Weise ist die Schaltung nach Figur 7 aus der der Figur 4 entstanden.

Die Figuren 8, 9 und 10 sind nur nummernmäßig jedoch nicht inhaltlich existent.

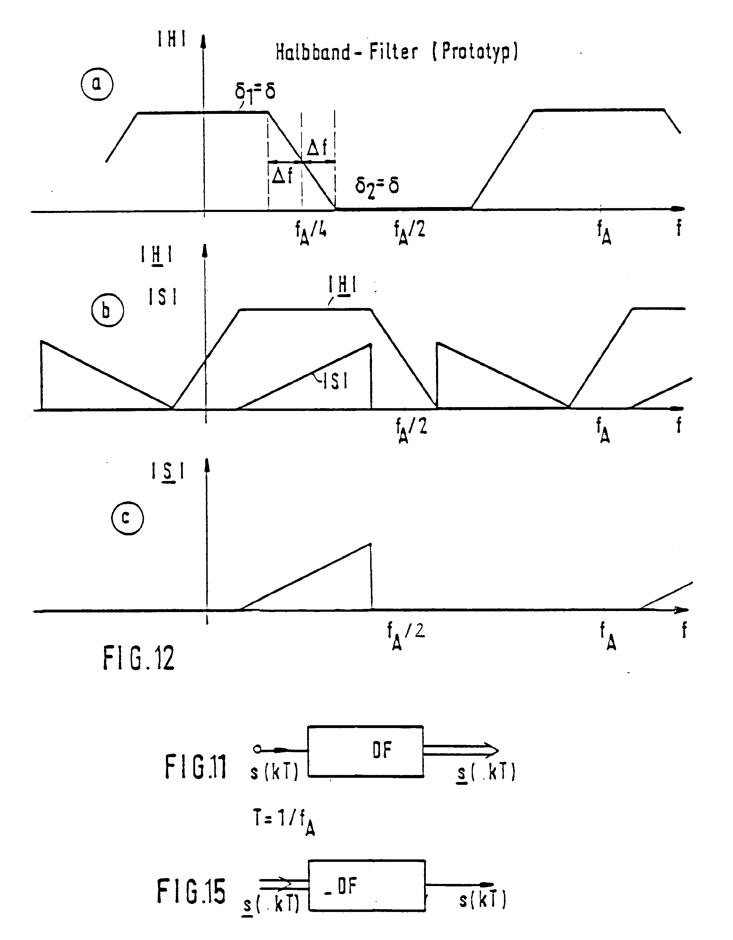

Die Figur 11 zeigt das Blockschaltbild des erfindungsgemäßen Digitalfilters.

In Figur 12a bis 12c sind einige Amplitudenantworten von Halb-Band-Filtern über der Frequenz aufgetragen.

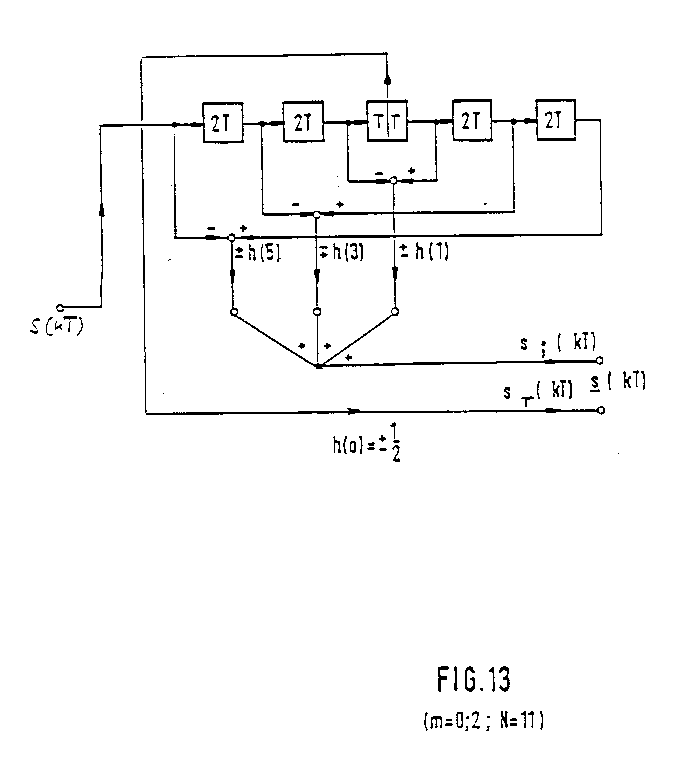

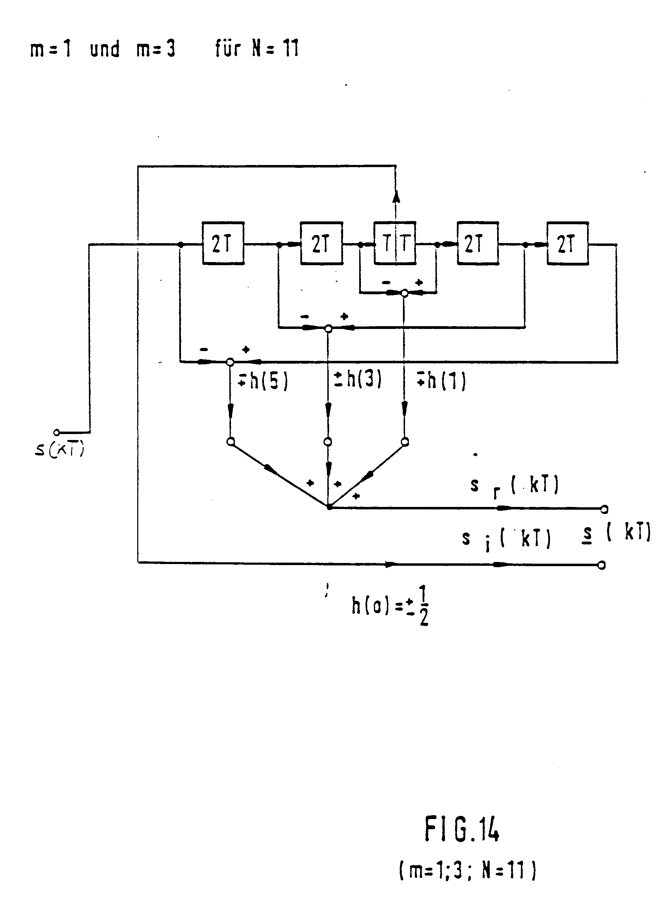

Die Figuren 13 und 14 zeigen besonders günstige Schaltungsvarianten des Halb-Band-Filters.

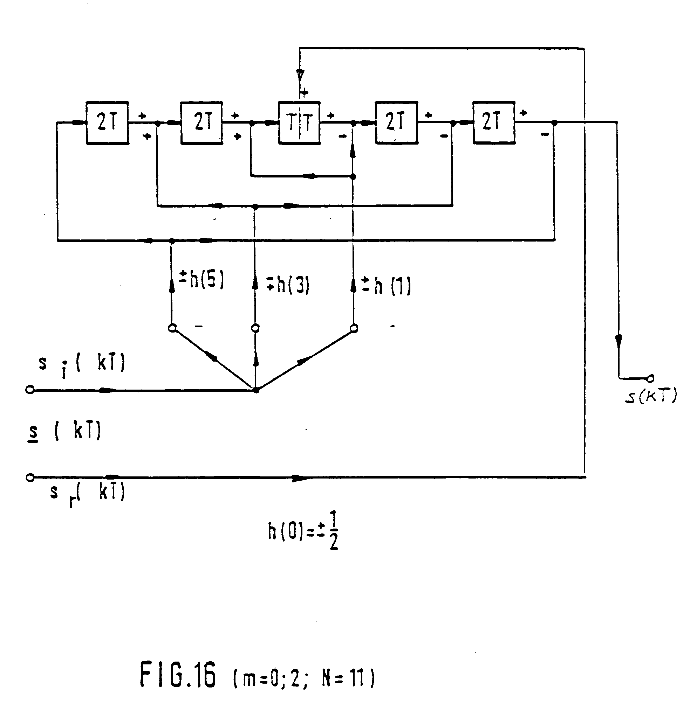

In Figur 15 schließlich ist das Blockschaltbild eines transponierten, umgekehrt betriebenen Halb-Band-Filters zur Verarbeitung eines komplexen Eingangssignals in ein reelles Ausgangssignal gezeichnet.

Die Figur 16 zeigt die detaillierte Schaltung des Filters nach Fig. 15, wobei diese Schaltung aus der Figur 13 durch Transposition entwickelt wurde, d.h. durch Umkehrung aller Pfeilrichtungen und den Ersatz einer Verzweigung durch einen Addierer und umgekehrt.

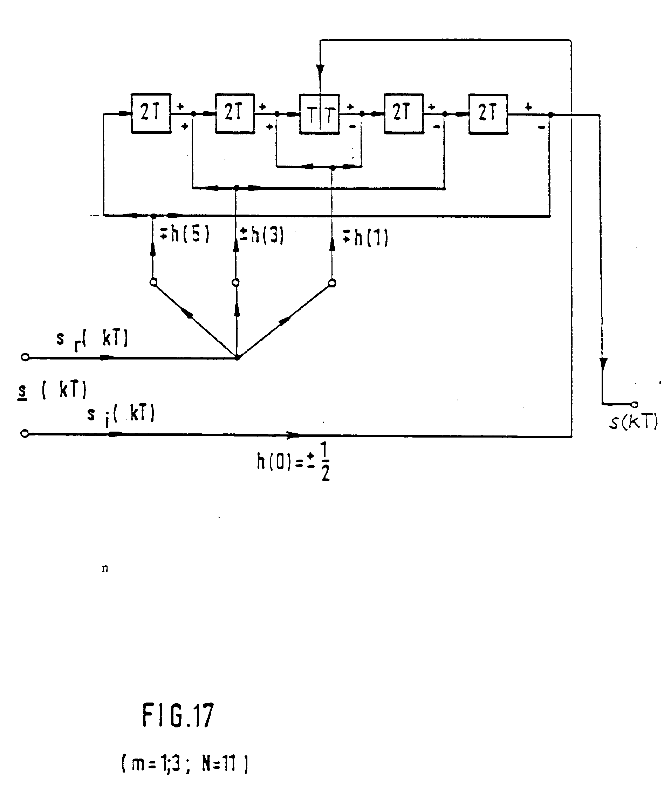

In entsprechender Weise ist die Schaltung nach Figur 17 aus der der Figur 14 entstanden.

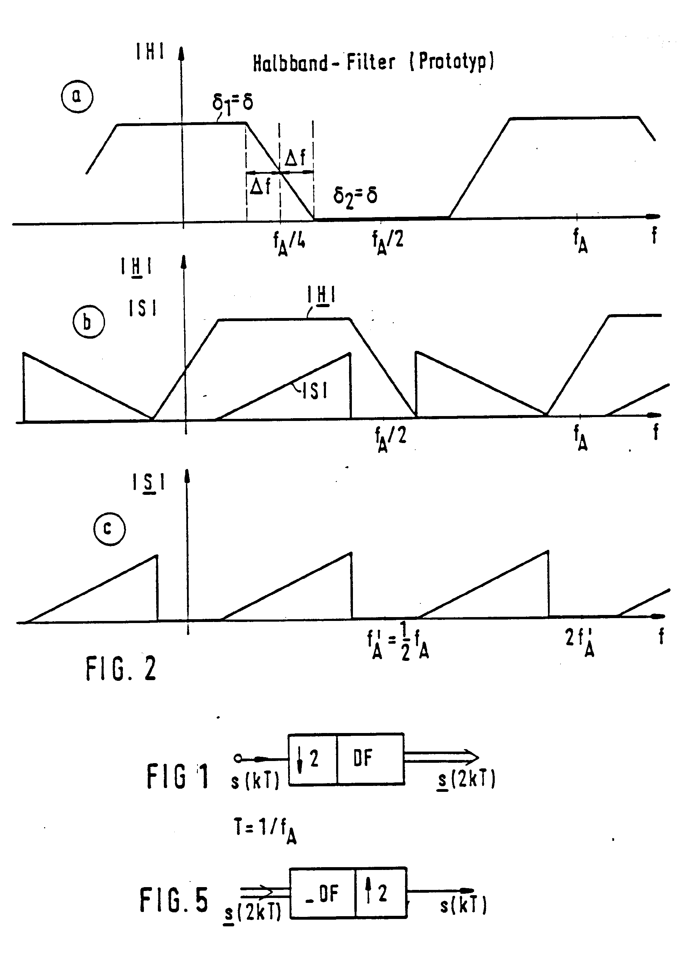

In Figur 1 wird das reelle Eingangssignal s(kT) durch Halbierung der Abtastrate dem digitalen Halb-Band-Filter DF zugeführt, welches daraus das komplexe Ausgangssignal $\underline{s}$(2kT) erzeugt.

In Figur 2a ist die Amplitudenfrequenzantwort eines Prototyp-Halb-Band-Filters erkennbar, sein Durchlaßbereich reicht von -fA/4 +$\Delta$f bis +fA/4 -$\Delta$f, und sein Sperrbereich ist ebenfalls fA/2 -2$\Delta$f breit. Kennzeichnend für das Halb-Band-Filter ist weiterhin, daß der Übergang vom Sperr- zum Durchlaßbereich stetig ist und auf einer Breite von 2Δf erfolgt. Dieser Übergangsbereich ist symmetrisch zu fA/4 angeordnet. Ein weiteres Kennzeichen des Halb-Band-Filters ist, daß sein Ripple im Durchlaß- und Sperrbereich gleich ist, nämlich δ1 = δ2 = δ. Bei einem solchen Filter ergibt sich eine Impulsantwort h(1) mit 1 = 0 bis N-1 und der ungeraden Filterlänge N, und es ergibt sich, daß jeder 2. Wert identisch Null ist, ausgenommen der mittlere Hauptwert (s. hierzu auch Fig. 2 auf S. 233 in dem o.g. Aufsatz von Bellanger et al).

Die Figur 2b zeigt den Frequenzgang |H|. Man sieht, daß dieser Frequenzgang um die Frequenz fA/4 gegenüber dem Frequenzgang des Prototyp-Halb-Band-Filters nach rechts verschoben ist. In die Figur 2b ist zusätzlich das Spektrum |S| eines reellen mit der Abtastfrequenz fA abgetasteten Eingangssignals s(kT) eingezeichnet, das sich aufgrund der Abtastung mit fA in den Frequenzbereichen [m·fA, (m+1/2)·fA] in Regellage und in den Frequenzbereichen [(m+1/2)·fA, (m+1)·fA] in Kehrlage mit m = ... -1, 0, +1 ... periodisch wiederholt. Das Eingangssignal s(kT), angewandt auf das erfindungsgemäße Halb-Band-Filter ohne Abtastratenänderung, würde also die Kehrlage zwischen fA/2 und fA und natürlich mit sämtlichen Wiederholungen unterdrücken und gleichzeitig ein komplexes Signal $\underline{s}$(kT) erzeugen. Eine Abtastratenhalbierung bringt nun die gewünschten Spektren, wobei die Normallage jeweils im Raster von fA/2 = fA', also der neuen Abtastrate wiederholt wird, s. Fig. 2c.

An dieser Stelle sei erwähnt, daß man am Ausgang des Halb-Band-Filters ein komplexes Signal in Kehrlage erhält, wenn der Frequenzgang des Prototyp-Halb-Band-Filters gemäß Figur 2a um -fA/4 oder, was gleichbedeutend ist, um +3fA/4 verschoben wird.

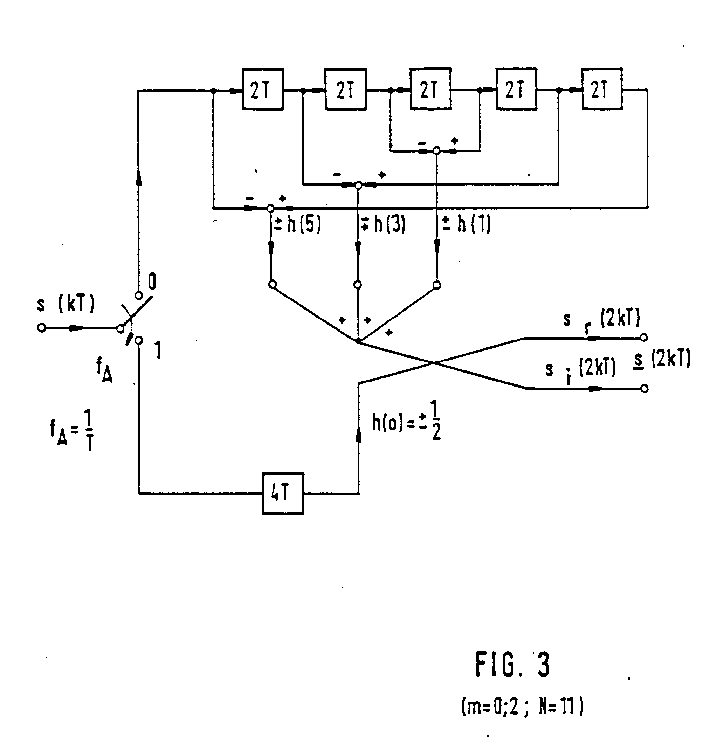

Die Figur 3 zeigt nun ein detaillierteres Ausführungsbeispiel eines erfindungsgemäßen Halb-Band-Filters. Zunächst sei jedoch noch etwas zu Fig. 2 gesagt, wonach ja die Abtastratenhalbierung erst nach der Filterung angesprochen wurde. Diese Reihenfolge des Vorgehens nach Fig. 2 wäre formal zu befolgen, jedoch kann gemäß der Erfindung das Halb-Band-Filter in 2 Zweige aufgeteilt werden, welche von vornherein schon jeweils mit jedem 2. Abtastwert des Eingangssignals versorgt werden. Dies bedeutet aber nichts anderes, als daß, wie auch im Blockschaltbild der Fig. 1 angegeben, die Abtastratenhalbierung direkt am Filtereingang erfolgen kann.

Entsprechend enthalten die detaillierteren Schaltungsausführungen der Figuren 3 und 4 einen eingangsseitigen Demultiplexer-Schalter, welcher mit dem Eingangssignal s(kT) einmal den oberen Zweig und zum anderen den unteren Zweig jeweils im Takte der Abtastrate fA' = fA/2 versorgt. Sowohl Figur 3 als auch Figur 4 stellt beispielhaft eine Realisierung dar für eine Filterlänge N = 11. Dementsprechend enthält der untere Zweig ein Verzögerungsglied der Verzögerungszeit (N-3).T/2 = 4T, während der obere Zweig eine Kette von 5 Verzögerungsgliedern der Verzögerungszeit 2T enthält.

In Figur 3 sind nun 2 Realisierungen dargestellt, nämlich für einen Modulationsphasenwinkel φ0 = 0 und φ0 = π entsprechend m = 0 und m = 2. Das Ausgangssignal des Verzögerungsgliedes des unteren Zweiges wird mit h(0) = 1/2 bewertet (multipliziert) und ergibt damit den Realteil $s_r$(2kT) des Ausangssignals. Bei m = 2 wird mit -1/2 bewertet. Die weitere Verarbeitung des oberen Zweiges erfolgt nun derart, daß (N+1)/4 = 3 Differenzsignale gebildet werden:

1. Differenzsignal = Eingangssignal des 1. minus Ausgangssignal des letzten Verzögerungsgliedes,

2. Differenzsignal = Eingangssignal des 2. minus Ausgangssignal des zweitletzten Verzögerungsgliedes und

3. Differenzsignal = Eingangssignal des 3. minus Ausgangssignal des drittletzten also des mittleren Verzögerungsgliedes.

Anschließend werden diese Differenzsignale bewertet (multipliziert), summiert und ergeben somit den Imaginärteil des Ausgangssignals $\underline{s}_i$(2kT). Die Bewertung erfolgt nach den folgenden Tabellen.

Beispiele für N = 11 und $\bar{h}$(1) = h(1) für 1 = 0, 1, ... 5, entsprechend dem Prototyp-Halb-Band-Filter gemäß Frequenzgang Figur 2a:

Tabelle 1 (zu Fig. 3):

m = 0 (m = 2 mit jeweils anderem Vorzeichen der komplexen Koeffizienten $\underline{h}$ = Re($\underline{h}$) + jJm($\underline{h}$))

| 1 | -5 | -3 | -1 | 0 | 1 | 3 | 5 |
|---|---|---|---|---|---|---|---|
| Re($\underline{h}$) | 0 | 0 | 0 | h(0) | 0 | 0 | 0 |
| Jm($\underline{h}$) | -h(5) | h(3) | -h(1) | 0 | h(1) | -h(3) | h(5) |

Tabelle 2 (Zu Fig. 4):

m = 1 (m = 3 mit jeweils anderen Vorzeichen der komplexen Koeffizienten)

| l | −5 | −3 | −1 | 0 | 1 | 3 | 5 |
|---|----|----|----|---|---|---|---|
| Re($\underline{h}$) | h(5) | −h(3) | h(1) | 0 | −h(1) | h(3) | −h(5) |
| Jm($\underline{h}$) | 0 | 0 | 0 | h(0) | 0 | 0 | 0 |

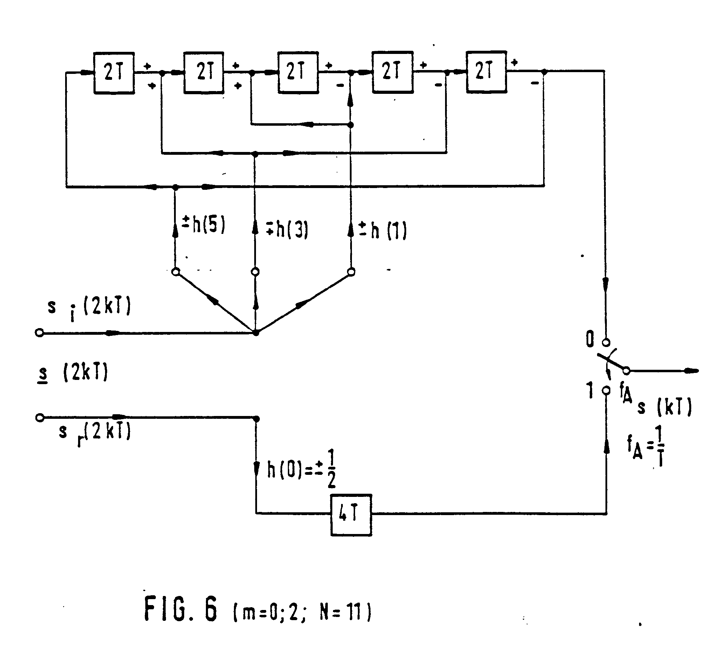

Die Realisierung gemäß Fig. 4 erfolgt in der gleichen Weise wie die nach der Figur 3, der Unterschied liegt allein im anderen Nullphasenwert $\varphi 0 = m \cdot \pi/2$ mit m = 1 und 3, was lediglich eine andere Bewertung und einen Tausch der Filterzweigausgänge zur Folge hat. Die Figur 5 zeigt das Blockschaltbild für den umgekehrten Einsatz des Halb-Band-Filters nach Figur 1, nämlich zur Erzeugung eines reellen Ausgangssignals aus einem komplexen Eingangssignal. Hierzu hat eine Transposition der bisher vorgestellten Schaltungen zu erfolgen, was eine Umkehrung aller Pfeilrichtungen und ein Ersatz einer Verzweigung durch einen Addierer und umgekehrt sowie den Ersatz eines Demultiplexers durch einen Multiplexer zur Folge hat. In entsprechender Weise gehen das Schaltungsausführungsbeispiel der Figur 6 aus der Figur 3 und die Schaltung nach Figur 7 aus Figur 4 hervor.

In Figur 11 wird das reelle Eingangssignal s(kT) dem digitalen Halb-Band-Filter DF zugeführt, welches daraus das komplexe Ausgangssignal $\underline{s}$(kT) erzeugt.

In Figur 12a ist die Amplitudenfrequenzantwort eines Prototyp-Halb-Band-Filters erkennbar, sein Durchlaßbereich reicht von -fA/4 +$\Delta$f bis +fA/4 -$\Delta$f (Halbwert), und sein Sperrbereich ist ebenfalls fA/2 -2$\Delta$f breit. Kennzeichnend für das Halb-Band-Filter ist weiterhin, daß der Übergang vom Sperr- zum Durchlaßbereich stetig ist und auf einer Breite von 2$\Delta$f erfolgt. Dieser Übergangsbereich ist symmetrisch zu fA/4 angeordnet. Ein weiteres Kennzeichen des Halb-Band-Filters ist, daß sein Ripple im Durchlaß- und Sperrbereich gleich ist, nämlich $\delta 1 = \delta 2 = \delta$. Bei einem solchen Filter ergibt sich eine Impulsantwort h(1) mit 1 = 0 bis N-1 und der ungeraden Filterlänge N, und es ergibt sich, daß jeder 2. Wert identisch Null ist, ausgenommen der mittlere Hauptwert (s. hierzu auch Fig. 2 auf S. 233 in dem o.g. Aufsatz von Bellanger et al).

Die Figur 12b zeigt den Frequenzgang $|\underline{H}|$. Man sieht, daß dieser Frequenzgang um die Frequenz fA/4 gegenüber dem Frequenzgang des Prototyp-Halb-Band-Filters nach rechts verschoben ist. In die Figur 12b ist zusätzlich das Spektrum $|S|$ eines reellen mit der Abtastfrequenz fA abgetasteten Eingangssignals s(kT) eingezeichnet, das sich aufgrund der Abtastung mit fA in den Frequenzbereichen [m·fA, (m+1/2)·fA] in Regellage und in den Frequenzbereichen [(m+1/2)·fA, (m+1)-fA] in Kehrlage mit m = ... -1, 0, +1 ... periodisch wiederholt. Vom reellwertigen Eingangssignal s(kT), angewandt auf das erfindungsgemäße Halb-Band-Filter ohne Abtastratenänderung, wird also die Kehrlage zwischen zwischen fA/2 und fA und natürlich mit sämtlichen Wiederholungen unterdrückt und gleichzeitig ein komplexes Signal $\underline{s}$(kT) erzeugt, s. Fig. 12c.

An dieser Stelle sei erwähnt, daß man am Ausgang des Halb-Band-Filters ein komplexes Signal in Kehrlage erhält, wenn der Frequenzgang des Prototyp-Halb-Band-Filters gemäß Figur 12a um -fA/4 oder, was gleichbedeutend ist, um +3fA/4 verschoben wird.

Die Figur 13 zeigt nun ein detaillierteres Ausführungsbeispiel eines erfindungsgemäßen Halb-Band-Filters. Sowohl Figur 13 als auch Figur 14 stellt beispielhaft eine Realisierung dar für eine Filterlänge N = 11 mit einer Kette von 6 Verzögerungsgliedern, davon 4 Verzögerungsglieder der Verzögerungszeit 2T und zwei symmetrisch zwischen den 4 Verzögerungsgliedern eingelagerten Glieder der Verzögerungszeit T.

In Figur 13 sind nun 2 Realisierungen dargestellt, nämlich für einen Modulationsphasenwinkel $\varphi 0 = 0$ und $\varphi 0 = \pi$ entsprechend m = 0 und m = 2. Das Ausgangssignal der Verzögerungsglieder der linken Kettenhälfte wird mit h(0) = 1/2 bewertet (multipliziert) und ergibt damit den Realteil $s_r$(kT) des Ausgangssignals. Bei m = 2 wird mit -1/2 bewertet. Die weitere Verarbeitung in der Verzögerungskette erfolgt nun derart, daß (N+1)/4 = 3 Differenzsignale gebildet werden:

1. Differenzsignal = Eingangssignal des 1. minus Ausgangssignal des letzten Verzögerungsgliedes,
2. Differenzsignal = Eingangssignal des 2. minus Ausgangssignal des zweitletzten Verzögerungsgliedes und
3. Differenzsignal = Eingangssignal des 3. minus Ausgangssignal des drittletzten also des rechten mittleren Verzögerungsgliedes. Anschließend werden diese Differenzsignale bewertet (multipliziert), summiert und ergeben somit den Imaginärteil des Ausgangssignals $\underline{s}$(kT). Die Bewertung erfolgt nach den folgenden Tabellen.

Beispiele für N = 11 und h(-1) = h(1) für 1 = 0, 1, ... 5, entsprechend dem Prototyp-Halb-Band-Filter gemäß Frequenzgang Figur 2a:

Tabelle 11 (zu Fig. 13):

m = 0 (m = 2 mit jeweils anderem Vorzeichen der komplexen Koeffizienten $\underline{h}$ = Re($\underline{h}$) + jJm($\underline{h}$))

| 1 | -5 | -3 | -1 | 0 | 1 | 3 | 5 |
|---|---|---|---|---|---|---|---|
| Re($\underline{h}$) | 0 | 0 | 0 | h(0) | 0 | 0 | 0 |
| Jm($\underline{h}$) | -h(5) | h(3) | -h(1) | 0 | h(1) | -h(3) | h(5) |

Tabelle 12 (Zu Fig. 14):

m = 1 (m = 3 mit jeweils anderen Vorzeichen der komplexen Koeffizienten)

| 1 | -5 | -3 | -1 | 0 | 1 | 3 | 5 |
|---|---|---|---|---|---|---|---|
| Re($\underline{h}$) | h(5) | -h(3) | h(1) | 0 | -h(1) | h(3) | -h(5) |
| Jm($\underline{h}$) | 0 | 0 | 0 | h(0) | 0 | 0 | 0 |

Die Realisierung gemäß Fig. 14 erfolgt in der gleichen Weise wie die nach der Figur 13, der Unterschied liegt allein im anderen Nullphasenwert $\varphi 0$ = m · $\pi$/2 mit m = 1 und 3, was lediglich eine andere Bewertung zur Folge hat.

Die Figur 15 zeigt das Blockschaltbild für den umgekehrten Einsatz des Halb-Band-Filters nach Figur 11, nämlich zur Erzeugung eines reellen Ausgangssignals aus einem komplexen Eingangssignal. Hierzu hat eine Transposition der bisher vorgestellten Schaltungen zu erfolgen, was eine Umkehrung aller Pfeilrichtungen und ein Ersatz einer Verzweigung durch einen Addierer und umgekehrt zur Folge hat. In entsprechender Weise gehen das Schaltungsausführungsbeispiel der Figur 16 aus der Figur 13 und die Schaltung nach Figur 17 aus Figur 14 hervor.

**Patentansprüche**

1. Nichtrekursives Halb-Band-Filter mit komplexen Koeffizienten zur Verarbeitung eines reellwertigen Eingangssignals s(kT) unter Halbierung der Abtastfrequenz fA = 1/T und zur Umwandlung dieses reellwertigen Eingangssignals s(kT) in ein komplexwertiges Ausgangssignal $\underline{s}$(2kT), dadurch gekennzeichnet, daß seine komplexen Koeffizienten $\underline{h}$(1) mit 1 = -(N-1)/2 bis (N-1)/2 und der ungeraden Filterlänge N, abwechselnd rein reelle und rein imaginäre Werte, also keine im Vollsinne komplexen Werte aufweisen, daß die Impulsantwort eines Halb-Band-Filters h(1) mit ausschließlich reellen Werten, mit den Eigenschaften h(1) = h(-1) für alle | 1 | ≦ (N-1)/2 und h(1) = 0 für 1 = ±2, ±4, ..., auf den komplexen Träger einer Frequenz von ±1/4 der Eingangs-Abtastfrequenz fA = 1/T moduliert wird zu

$$\underline{h}(l) = h(l) \cdot e^{j(\pm 2\pi lfA/4fA + \varphi)0} = j^{\pm l} \cdot e^{j\varphi 0} \cdot h(l)$$ und

daß die Nullphase $\varphi 0$ dieses komplexen Trägers ganze Vielfache m von $\pi$/2 beträgt ($\varphi 0$ = m · $\pi$/2 mit m = 0, 1, 2, 3 ...).

2. Nichtrekursives Halb-Band-Filter, mit komplexen Koeffizienten zur Verarbeitung eines komplexwertigen Eingangssignals $\underline{s}$(2kT) und zur Verdoppelung der Abtastfrequenz fA' = 1/2T auf fA = 2fA' und zur Umwandlung dieses komplexwertigen Eingangssignals $\underline{s}$(2kT) in ein reelwertiges Ausgangssignal s(kT), dadurch gekennzeichnet, daß seine komplexen Koeffizienten $\underline{h}$(l) mit 1 = -(N-1)/2 bis (N-1)/2 und der ungeraden Filterlänge N, abwechselnd rein reelle und rein imginäre Werte, also keine im Vollsinne komplexen Werte aufweisen, daß die Impulsantwort eines Halb-Band-Filters h(l) mit ausschließlich reellen Werten, mit den Eigenschaften h(l) = h(-l) für alle $|1| \leqq$ (N-1)/2 und h(l) = 0 für 1 = ±2, ±4, ..., auf den komplexen Träger einer Frequenz von ±1/4 der Ausgangs-Abtastfrequenz fA = 1/T moduliert wird zu

$$\underline{h}(l) = h(l) \cdot e^{j(\pm 2\pi l fA/4fA) + \varphi 0)} = j^{\pm 1} \cdot e^{j\varphi 0} \cdot h(l) \text{ und}$$

daß die Nullphase φ0 dieses komplexen Trägers ganze Vielfache m von π/2 beträgt (φ0 = m · π/2 mit m = 0, 1, 2, 3 ...).

3. Nichtrekursives Halb-Band-Filter nach Anspruch 1, dadurch gekennzeichnet,
daß jeder 2. Abtastwert des Eingangssignals s(kT) in eine Kette von (N-1)/2 Verzögerungsgliedern der Verzögerungszeit 2T geleitet wird, daß jeweils Differenzsignale gebildet werden aus Ausgangssignal des letzten Verzögerungsgliedes minus Eingangssignal des 1. Verzögerungsgliedes = 1. Differenzsignal, Ausgangssignal des zweitletzten Verzögerungsgliedes minus Eingangssignal des 2. Verzögerungsgliedes = 2. Differenzsignal, Ausgangssignal des drittletzten Verzögerungsgliedes minus Eingangssignal des 3. Verzögerungsgliedes = 3. Differenzsignal usw.,
daß diese Differenzsignale einer Bewertung (Multiplikation) mit einem Wert h(l) der Impulsantwort unterworfen werden und anschließend summiert werden und dann entweder den Real- oder Imaginärteil des Filterausgangssignals $\underline{s}$(2kT) ergeben, daß in einem 2. Zweig ein Verzögerungsglied mit der Verzögerungszeit T.(N - 3)/2 vorgesehen ist, in das jeder 2. gegenüber obigen Abtastwerten versetzte Abtastwert des Eingangssignals geleitet wird und dessen Ausgangssignal, mit dem Wert h(0) bewertet, den Imaginär- oder Realteil des Filterausgangssignals $\underline{s}$(2kT) ergibt.

4. Nichtrekursives Halb-Band-Filter nach Anspruch 3, mit N = 11 und m = 1, dadurch gekennzeichnet,
daß das 1. Differenzsignal mit -h(5), das 2. Differenzsignal mit h(3) und das 3. mit -h(1) bewertet werden daß h(0) = 1/2 ist und
daß die Summe der Differenzsignale den Realteil $s_r$(2kT) und das mit h(0) bewertete Signal den Imaginärteil $s_i$(2kT) ergeben (Fig. 4).

5. Nichtrekursives Halb-Band-Filter nach Anspruch 3, mit N = 11 und m = 3, dadurch gekennzeichnet,
daß die Bewertung des 1. Differenzsignals mit h(5), des 2. mit -h(3), des 3. mit h(1) erfolgt und daß h(0) = -1/2 ist und daß die Summe der Differenzsignale den Realteil $s_r$(2kT) und das mit h(0) bewertete Signal den Imaginärteil $s_i$(2kT) ergeben (Fig. 4).

6. Nichtrekursives Halb-Band-Filter nach Anspruch 3, mit N = 11 und m = 0, dadurch gekennzeichnet,
daß die Bewertung des 1. Differenzsignals mit h(5), des 2. mit -h(3) und des 3. mit h(1) erfolgt und
daß die Summe der Differenzsignale den Imaginärteil $s_i$(2kT) und das mit h(0) = 1/2 bewertete Signal den Realteil $s_r$(2kT) ergeben (Fig. 3).

7. Nichtrekursives Halb-Band-Filter nach Anspruch 3, mit N = 11 und m = 2, dadurch gekennzeichnet,
daß die Bewertung des 1. Differenzsignals mit -h(5), des 2. mit h(3), des 3. mit -h(1) erfolgt und
daß die Summe der Differenzsignale den Imaginärteil $s_i$(2kT) und das mit h(0) = -1/2 bewertete Signal den Realteil $s_r$(2kT) ergeben (Fig. 3).

8. Nichtrekursives Halb-Band-Filter nach Anspruch 2, dadurch gekennzeichnet,
daß eine Kette von (N-1)/2 Verzögerungsgliedern der Verzögerungszeit 2T vorgesehen ist, daß der mit einem Wert h(1) der Impulsantwort bewertete Realteil $s_r$(2kT) dem 1. Verzögerungsglied dieser Kette zugeführt und vom Ausgangssignal des letzten Verzögerungsgliedes dieser Kette abgezogen wird, welches Differenzsignal jeden 2. Abtastwert des reellen Filterausgangssignals s(kT) liefert,
daß auf das Transversalsignal dieser Verzögerungsgliederkette an den weiteren Punkten zusätzliche mit einem Wert h(1) der Impulsantwort bewertete Augenblickswerte des Realteils $s_r$(2kT) des Filtereingangssignals addiert werden,
daß ein weiteres Verzögerungsglied der Verzögerungszeit T.(N-3)/2 vorgesehen ist, in dessen Eingang der mit h(0) bewertete Imaginärteil $s_i$(2kT) eingegeben wird und dessen Ausgang jeden zeitlich versetzten 2. Abtastwert des reellen Filterausgangssignals s(kT) liefert.

9. Nichtrekursives Halb-Band-Filter nach Anspruch 8, mit m = 0 und N = 11, dadurch gekennzeichnet,
daß die Bewertung der zugeführten Augenblickswerte des Realteils $s_r$(2kT) des Filtereingangssignals wie folgt erfolgt:

am Eingang des 1. Verzögerungsgliedes h(5),
am Eingang des 2. Verzögerungsgliedes -h(3),
am Eingang des 3. Verzögerungsgliedes h(1),
am Eingang des 4. Verzögerungsgliedes -h(1),
am Eingang des 5. Verzögerungsgliedes h(3) und
am Ausgang des 5. Verzögerungsgliedes -h(5) und
daß h(0) = 1/2 ist (Fig. 6).

10. Nichtrekursives Halb-Band-Filter, dessen reelles Eingangssignal s(kT) unter Beibehaltung der Abtastfrequenz fA = 1/T in ein komplexes Ausgangssignal s̲(kT) mit k als laufendem Index umgewandelt wird, indem seine Impulsantwort h(1), mit 1 = -(N-1)/2 bis (N-1)/2 und der ungeraden Filterlänge N, auf den komplexen Träger einer Frequenz von ±1/4 der Abtastfrequenz fA = 1/T moduliert wird zu

$$\underline{h}(l) = h(l) \cdot e^{j(\pm 2\pi l fA/4fA) + \varphi 0)} = j^{\pm l} \cdot e^{j \varphi 0} \cdot h(l)\ \text{und}$$

wobei di Nullphase φ0 dieser Frequenz ganze Vielfache m von $\pi/2$ mit m = 0, 1, 2, 3....), wobei jeweils Differenzsignale gebildet werden aus Ausgangssignal des letzten Verzögerungsgliedes minus Eingangssignal des 1. Verzögerungsgliedes = 1. Differenzsignal, Ausgangssignal des zweitletzten Verzögerungsgliedes minus Eingangssignal des 2. Verzögerungsgliedes = 2. Differenzsignal, Ausgangssignal des drittletzten Verzögerungsgliedes minus Eingangssignal des 3. Verzögerungsgliedes = 3. Differenzsignal usw., wobei diese Differenzsignale einer Bewertung (Multiplikation) mit einem Wert h(l) der Impulsantwort unterworfen werden und anschließend summiert werden und dann entweder den Real- oder Imaginärteil des Filterausgangssignals s̲(kT) ergeben, dadurch gekennzeichnet, daß die Abtastfrequenz fA = 1/T beibehalten wird,
daß jeder Abtastwert des Eingangssignals s(kT) in eine Kette von (N-1)/2 Verzögerungsgliedern der Verzögerungszeit 2T geleitet wird, wobei das mittlere Verzögerungsglied aufgetrennt ist in zwei Glieder mit der Verzögerungszeit T,
und daß aus der Kettenmitte das mit der Verzögerungszeit T · (N - 1)/2 verzögerte Eingangssignal mit dem Wert h(0) bewertet wird, welches den Imaginär- oder Realteil des Filterausgangssignals s̲(kT) ergibt.

11. Nichtrekursives Halb-Band-Filter, dessen komplexes Eingangssignal s̲(kT) mit k als laufendem Index in ein reelles Ausgangssignal s(kT) umgewandelt wird, indem seine auf die Abtastfrequenz fA bezogene Impulsantwort h(l), mit 1 = -(N-1)/2 bis (N-1)/2 und der ungeraden Filterlänge N, auf den komplexen Träger einer Frequenz ±fA/4 moduliert wird zu $\underline{h}(l) = h(l) \cdot e^{j(\pm 2\pi l fA/4fA) + \varphi 0)} = j^{\pm l} \cdot e^{j\varphi 0} \cdot h(l)$ und
wobei die Nullphase φ0 dieser Frequenz ganze Vielfache m von $\pi/2$ beträgt ($\varphi 0 = m \cdot \pi/2$ mit m = 0, 1, 2, 3 ...), wobei der mit einem Wert h(l) der Impulsantwort bewertete Imaginärteil $s_i(kT)$ dem 1. Verzögerungsglied dieser Kette zugeführt und vom Ausgangsignal des letzten Verzögerungsgliedes dieser Kette abgezogen wird, welches Differenzsignal das reelle Filterausgangssignal s(kT) liefert, wobei auf das Transversalsignal dieser Verzögerungsgliederkette an den weiteren Punkten zusätzliche mit einem Wert h(l) der Impulsantwort bewertete Augenblickswerte des Imäginärteils $s_i(kT)$ des Filtereingangssignals addiert werden, dadurch gekennzeichnet, daß die Abtastfrequenz fA = 1/T beibehalten wird,
daß eine Kette von (N-1)/2 Verzögerungsgliedern der Verzögerungszeit 2T vorgesehen ist, wobei das mittlere Verzögerungsglied aufgetrennt ist in zwei Glieder mit der Verzögerungszeit T,
und daß in die Mitte der Verzögerungskette der Realteil $s_r(kT)$ des komplexen Filtereingangssignals additiv zum Transversalsignal der Kette mit h(0) bewertet, eingegeben wird.

12. Nichtrekursives Halb-Band-Filter nach Anspruch 10, mit N = 11 und m = 1, dadurch gekennzeichnet, daß das 1. Differenzsignal mit -h(5), das 2. Differenzsignal mit h(3) und das 3. mit -h(1) bewertet werden und daß h(0) = 1/2 ist und
daß die Summe der Differenzsignale den Realteil $s_r(kT)$ und das mit h(0) bewertete Signal den Imaginärteil $s_i(kT)$ ergeben (Fig. 14).

13. Nichtrekursives Halb-Band-Filter nach Anspruch 10, mit N = 11 und m = 3, dadurch gekennzeichnet, daß die Bewertung des 1. Differenzsignals mit h(5), des 2. mit -h(3), des 3. mit h(1) erfolgt und daß h(0) = -1/2 ist und daß die Summe der Differenzsignale den Realteil $s_r(kT)$ und das mit h(0) bewertete Signal den Imaginärteil $s_i(kT)$ ergeben (Fig. 14)

14. Nichtrekursives Halb-Band-Filter nach Anspruch 10, mit N = 11 und m = 0, dadurch gekennzeichnet, daß die Bewertung des 1. Differenzsignals mit h(5), des 2. mit -h(3) und des 3. mit h(1) erfolgt und

daß die Summe der Differenzsignale den Imaginärteil $s_i(kT)$ und das mit $h(0) = 1/2$ bewertete Signal den Realteil $s_r(kT)$ ergeben (Fig. 13).

15. Nichtrekursives Halb-Band Filter nach Anspruch 10, mit $N = 11$ und $m = 2$, dadurch gekennzeichnet,

daß die Bewertung des 1. Differenzsignals mit $-h(5)$, des 2. mit $h(3)$, des 3. mit $-h(1)$ erfolgt und

daß die Summe der Differenzsignale den Imaginärteil $s_i(kT)$ und das mit $h(0) = -1/2$ bewertete Signal des Realteils $s_r$ ergeben (Fig. 13).

16. Nichtrekursives Halb-Band-Filter nach Anspruch 11, mit $m = 0$ bzw. 2 und $N = 11$, dadurch gekennzeichnet,

daß die Bewertung der zugeführten Augenblickswerte des Realteils $s_r(kT)$ bzw. des Imaginärteils $s_i(kT)$ des Filtereingangssignals wie folgt erfolgt:

am Eingang des 1. Verzögerungsgliedes $\pm h(5)$,

am Eingang des 2. Verzögerungsgliedes $\pm h(3)$,

am Eingang des 3. Verzögerungsgliedes $\pm h(1)$,

am Eingang des zweitletzten Verzögerungsgliedes $\pm h(1)$,

am Eingang des letzten Verzögerungsgliedes $\pm h(3)$ und

am Ausgang des letzten Verzögerungsgliedes $\pm h(5)$ und

daß $h(0) = \pm 1/2$ ist (Fig. 16).


## Claims

1. A non-recursive half-band filter with complex coefficients for processing a real input signal $s(kT)$ by halving the sampling frequency $fA = 1/T$ and for converting this real input signal $s(kT)$ into a complex output signal $\underline{s}(2kT)$, characterised in that its complex coefficients $\underline{h}(\ell)$, where $\ell = -(N-1)/2$ to $(N-1)/2$ and the filter length $N$ is odd, have alternating purely real and purely imaginary values, therefore no complex values in the fullest sense; the pulse response of a half-band filter $h(\ell)$ having exclusively real values and the characteristics $h(\ell) = h(-\ell)$ for all $|\ell| \leq (N-1)/2$ and $h(\ell) = 0$ for $\ell = \pm 2, \pm 4, ...,$ is modulated onto the complex carrier at a frequency of $\pm \frac{1}{4}$ of the input sampling frequency $fA = 1/T$ to yield

$$\underline{h}(\ell) = h(\ell) \cdot e^{j(\pm 2\pi \ell fA/4fA) + \phi 0)} = j^{\pm \ell} \cdot e^{j\phi 0} \cdot h(\ell)$$

and the null phase $\phi 0$ of this complex carrier is an integer multiple $m$ of $\pi/2$ ($\phi 0 = m \cdot \pi/2$ where $m = 0, 1, 2, 3, ...$).

2. A non-recursive half-band filter with complex coefficients for processing a complex input signal $\underline{s}(2kT)$ and for doubling the sampling frequency $fA' = \frac{1}{2}T$ to $fA = 2fA'$ and for converting this complex input signal $\underline{s}(2kT)$ into a real output signal $s(kT)$, characterised in that its complex coefficients $\underline{h}(\ell)$, where $\ell = -(N-1)/2$ to $(N-1)/2$ and the filter length $N$ is odd, alternatingly have purely real and purely imaginary values, therefore no complex values in the fullest sense; the pulse response of a half-band filter $h(\ell)$ having exclusively real values and the characteristics $h(\ell) = h(-\ell)$ for all $|\ell| \leq (N-1)/2$ and $h(\ell) = 0$ for $\ell = \pm 2, \pm 4, ...,$ is modulated onto the complex carrier of a frequency of $\pm \frac{1}{4}$ of the output sampling frequency $fA = 1/T$ to yield $\underline{h}(\ell) = h(\ell) \cdot e^{j(\pm 2\pi \ell fA/4fA) + \phi 0)} = j^{\pm \ell} \cdot e^{j\phi 0} \cdot h(l)$ and the null phase $\phi 0$ of this complex carrier is an integer multiple $m$ of $\pi/2$ ($\phi 0 = m \cdot \pi/2$ where $m = 0, 1, 2, 3, ...$).

3. A non-recursive half-band filter according to claim 1, characterised in that each second sample of the input signal $s(kT)$ is routed into a chain of $(N-1)/2$ delay members having delay times of $2T$; in each case difference signals are formed from the output signal of the last delay member minus the input signal of the first delay member to equal the first difference signal; from the output signal of the penultimate delay member minus the input signal of the second delay member to equal the second difference signal; from the output signal of the third last delay member minus the input signal of the third delay member to equal the third difference signal, etc; these difference signals are subjected to weighting (multiplication) with a value $h(\ell)$ of the pulse response and are them summed, and then yield either the real or the imaginary component of the filter output signal $\underline{s}(2kT)$; in a second branch there is provided a delay member which has a time delay of $T \cdot (N-3)/2$, into which is routed every second sample of the input signal that is shifted relative to the above samples, the output signal of said delay member, weighted with the value $h(0)$, yielding the imaginary or the real component of the filter output signal $\underline{s}(2kT)$.

4. A non-recursive half-band filter according to claim 3, where $N = 11$ and $m = 1$, characterised in that the first difference signal is weighted with $-h(5)$, the second difference signal with $h(3)$ and the third difference signal with -h(1); h(0) = ½; and the sum of the difference signals yields the real component $s_r$(2kT) while the signal weighted with h(0) yields the imaginary component $s_i$(2kT) (Figure 4).

5. A non-recursive half-band filter according to claim 3, where N = 11 and m = 3, characterised in that the first difference signal is weighted with h(5), the second with -h(3), the third with h(1); and h(0) = -½; and the sum of the difference signals yields the real component $s_r$(2kT) while the signal weighted with h(0) yields the imaginary component $s_i$(2kT) (Figure 4).

6. A non-recursive half-band filter according to claim 3, wherein N = 11 and m = 0, characterised in that the first difference signal is weighted with h(5), the second with -h(3), and the third with h(1); and the sum of the difference signals yields the imaginary component $s_i$(2kT) while the signal weighted with h(0) = -½ yields the real component $s_r$(2kT) (Figure 3).

7. A non-recursive half-band filter according to claim 3, where N = 11 and m = 2, characterised in that the first difference signal is weighted with -h(5), the second with h(3), the third with -h(1); and the sum of the difference signals yields the imaginary component $s_i$(2kT) while the signal weighted with h(0) = -½ yields the real component $s_r$(2kT) (Figure 3).

8. A non-recursive half-band filter according to claim 2, characterised in that a chain of (N-1)/2 delay members having a time delay of 2T is provided; the real component $s_r$(2kT) weighted with a value of h(l) of the pulse response is fed to the first delay member of this chain and is subtracted from the output signal of the last delay member of this chain, said difference signal furnishing every second sample of the real filter output signal s(kT); additional momentary values of the real component $s_r$(2kT) of the filter input signal weighted with a value h(l) of the pulse response are added to the transversal signal of this chain of delay members at the further points.

9. A non-recursive half-band filter according to claim 8, where m = 0 and N = 11, characterised in that the weighting of the applied momentary values of the real component $s_r$(2kT) of the filter input signal is effected as follows:
   at the input of the first delay member with h(5);
   at the input of the second delay member with -h(3);
   at the input of the third delay member with h(1);
   at the input of the fourth delay member with -h(1);
   at the input of the fifth delay member with h(3); and
   at the output of the fifth delay member with -h(5);
where h(0) = ½ (Figure 6).

10. A non-recursive half-band filter, whose real input signal s(kT) is converted into a complex output signal $\underline{s}$(kT) where k is a running index, while maintaining the sampling frequency fA = 1/T, in that its pulse response h($\ell$), where $\ell$ = -(N-1)/2 to (N-1)/2 and the filter length N is odd, is modulated onto the complex carrier of a frequency of ±¼ of the sampling frequency fA = 1/T, to yield
$$\underline{h}(\ell) = h(\ell) \cdot e^{j(\pm 2\pi \ell fA/4fA) + \phi 0)} = j^{\pm \ell} \cdot e^{j\phi 0} \cdot h(\ell)$$
and the null phase $\phi 0$ of this frequency is an integer multiple m of $\pi/2$, where m = 0, 1, 2, 3, ..., with difference signals being formed in each case from the output signal of the last delay member minus the input signal of the first delay member to equal the first difference signal; from the output signal of the penultimate delay member minus the input signal of the second delay member to equal the second difference signal; from the output signal of the third last delay member minus the input signal of the third delay member to equal the third difference signal, etc; these difference signals are subjected to weighting (multiplication) with a value h($\ell$) of the pulse response and are then summed, and then yield either the real or the imaginary component of the filter output signal $\underline{s}$(2kT); characterised in that the sampling frequency fA = 1/T is retained;
   each sampled value of the input signal s(kT) is conducted into a chain of (N-1)/2 delay members having a delay time of 2T, with the middle delay member being separated into two members each having a delay of T; and
   the input signal delayed by the delay time T · (N1)/2 is weighted with the value h(0) to yield the imaginary or the real component of the filter output signal $\underline{s}$(kT).

11. A non-recursive half-band filter whose complex input signal $\underline{s}$(kT), where k is a running index, is converted into a real output signal s(kT) in that its pulse response h($\ell$) with reference to the sampling frequency fA,

where $\ell$ = -(N-1)/2 to (N-1)/2 and the filter length N is odd, is modulated onto the complex carrier of a frequency of ±fA/4 to yield

$$\underline{h}(\ell) \;=\; h(\ell) \cdot e^{j(\pm 2\pi\ell\, fA/4fA) \;+\; \phi 0)} \;=\; j^{\pm\ell} \cdot e^{j\phi 0} \cdot h(\ell)$$

and the null phase $\phi 0$ of this frequency is an integer multiple m of $\pi/2$ ($\phi 0$ = m · $\pi/2$ where m = 0, 1, 2, 3, ...), with the imaginary component $s_i(kT)$ weighted with a value $h(\ell)$ being fed to the first delay member of this chain and being subtracted from the output signal of the last delay member of this chain, which difference signal furnishes the real filter output signal s(kT), with additional momentary values of the imaginary component $s_i(kT)$ of the filter input signal weighted with a value $h(\ell)$ of the pulse response being added to the transverse signal of this delay member chain at the further points, characterised in that the sampling frequency fA = 1/T is retained;

a chain of (n-1)/2 delay members having a delay of 2T is provided, with the middle delay member being separated into two members each having a delay of T; and

the real component $s_r(kT)$ of the complex filter input signal, weighted with h(0), is fed in additively to the transverse signal of the chain into the middle of the delay chain.

12. A non-recursive half-band filter according to claim 10, where N = 11 and m = 1, characterised in that the first difference signal is weighted with -h(5), the second difference signal with h(3) and the third difference signal with -h(1); and h(0) = ½; and the sum of the difference signals yields the real component $s_r(kT)$ while the signal weighted with h(0) yields the imaginary component $s_i(kT)$ (Figure 14).

13. A non-recursive half-band filter according to claim 10, where N = 11 and m = 3, characterised in that the first difference signal is weighted with h(5), the second with -h(3), the third with h(1); and h(0) = -½; and the sum of the difference signals yields the real component $s_r(kT)$ while the signal weighted with h(0) yields the imaginary component $s_i(kT)$ (Figure 14).

14. A non-recursive half-band filter according to claim 10, wherein N = 11 and m = 0, characterised in that the first difference signal is weighted with h(5), the second with -h(3), and the third with h(1); and the sum of the difference signals yields the imaginary component $s_i(kT)$ while the signal weighted with h(0) = ½ yields the real component $s_r(kT)$ (Figure 13).

15. A non-recursive half-band filter according to claim 10, where N = 11 and m = 2, characterised in that the first difference signal is weighted with -h(5), the second with h(3), the third with -h(1); and the sum of the difference signals yields the imaginary component $s_i(kT)$ while the signal weighted with h(0) = -½ yields the real component $s_r(kT)$ (Figure 13).

16. A non-recursive half-band filter according to claim 11, where m = 0 and 2, respectively, and N = 11, characterised in that the weighting of the applied momentary values of the real component $s_r(kT)$ and of the imaginary component $s_i(kT)$, respectively, of the filter input signal is effected as follows:

at the input of the first delay member with ±h(5);
at the input of the second delay member with ±h(3);
at the input of the third delay member with ±h(1);
at the input of the penultimate delay member with ±h(1);
at the input of the last delay member with ±h(3); and
at the output of the last delay member with ±h(5); and h(0) = ±½ (Figure 16).

**Revendications**

1. Filtre demi-bande non récursif, à coefficients complexes, pour traiter un signal d'entrée réel s(kT) en divisant par deux la fréquence d'échantillonnage fA = 1/T et pour convertir ce signal d'entrée réel s(kT) en un signal de sortie complexe $\underline{s}(2kT)$, filtre caractérisé,

par le fait que ses coefficients complexes h(1) pour 1 = -(N-1)/2 à (N-1)/2 et pour la longueur impaire N du filtre, présentent alternativement des valeurs purement réelles et des valeurs purement imaginaires et donc aucune valeur complexe proprement dite,

Par le fait que l'on module la réponse impulsionnelle d'un filtre demi-bande h(1) avec des valeurs exclusivement réelles, de caractéristiques h(1) = h(-1) pour tous les |1| ≦ (N-1)/2 et h(1) = 0 pour 1 = ±2, ±4, ..., sur la porteuse complexe d'une fréquence de ±1/4 de la fréquence d'échantillonnage d'entrée fA = 1/T pour obtenir:

10

$$\underline{h}(l) = h(l) \cdot e^{j(\pm 2\pi lfA/4fA) + \varphi 0)} = j^{\pm l} \cdot e^{j\varphi 0} \cdot h(l)$$

et par le fait que la phase zéro degré 0 de cette porteuse complexe se présente pour tous les multiples m de $\pi/2$ ($\varphi 0 = m \cdot \pi/2$ avec m = 0, 1, 2, 3 ...).

2. Filtre demi-bande non récursif à coefficients complexes pour traiter un signal d'entrée complexe $\underline{s}(2kT)$ et pour doubler la fréquence d'échantillonnage fA' = 1/2T pour qu'elle devienne fA = 2fA' et pour convertir ce signal d'entrée complexe $\underline{s}(2kT)$ en un signal de sortie réel s(kT), filtre caractérisé

par le fait que ses coefficients complexes $\underline{h}(1)$ pour 1 = -(N-1)/2 à (N-1)/2 et pour la longueur impaire N du filtre, présentent alternativement des valeurs purement réelles et des valeurs purement imaginaires et donc aucune valeur complexe proprement dite,

par le fait que l'on module la réponse impulsionnelle d'un filtre demi-bande h(1) avec des valeurs exclusivement réelles, de caractéristiques h(1) = h(-1) pour tous les $1 \leqq (N-1)/2$ et h(1) = 0 pour 1 = +2, +4, ..., sur la porteuse complexe d'une fréquence de $\pm 1/4$ de la fréquence d'échantillonnage de sortie fA = 1/T pour obtenir:

$$\underline{h}(l) = h(l) \cdot e^{j(\pm 2\pi lfA/4fA) + \varphi 0)} = j^{\pm l} \cdot e^{j\varphi 0} \cdot h(l)$$

et par le fait que la phase zéro degré $\varphi 0$ de cette porteuse complexe se présente pour tous les multiples m de $\pi/2$ ($\varphi 0 = m \cdot \pi/2$ avec m = 0, 1, 2, 3 ...).

3. Filtre demi-bande non récursif selon la revendication 1, caractérisé,

par le fait que l'on amène une sur deux des valeurs d'échantillonnage du signal d'entrée s(kT) dans une chaîne de (N-1)/2 éléments retardateurs du temps de retardement 2T.

par le fait que l'on forme chaque fois des signaux de différence; à partir du signal de sortie du dernier élément retardateur moins le signal d'entrée du 1er élément retardateur = 1er signal de différence, signal de sortie du pénultième élément retardateur moins signal d'entrée du 2ème élément retardateur = 2ème signal de différence, signal de sortie de l'antépénultième élément retardateur moins signal d'entrée du 3ème élément retardateur = 3ème signal de différence etc.,

par le fait que l'on soumet ces signaux de différence à une pondération (multiplication) par une valeur h(1) de la réponse impulsionnelle et qu'ensuite on les additionne, obtenant ainsi soit la partie réelle soit la partie imaginaire du signal de sortie du filtre $\underline{s}(2kT)$,

par le fait que dans une seconde branche est prévu un élément retardateur du temps de retardement T.(N - 3)/2 dans lequel on amène une sur deux valeurs d'échantillonnage, décalée par rapport aux valeurs d'échantillonnage ci-dessus, du signal d'entrée, et dont le signal de sortie, pondéré avec la valeur h(0), donne la partie imaginaire ou la partie réelle du signal de sortie du filtre $\underline{s}(2kT)$.

4. Filtre demi-bande non récursif selon la revendication 3, avec N = 11 et m = 1, caractérisé

par le fait que l'on pondère le 1er signal de différence avec -h(5), le 2ème signal de différence avec h(3) et le 3ème avec -h(1),

par le fait que h(0) = 1/2 et

par le fait que la somme des signaux de différence donne la partie réelle $s_r(2kT)$ et que le signal pondéré avec h(0) donne la partie imaginaire $s_i(2kT)$ (figure 4).

5. Filtre demi-bande non récurcif selon la revendication 3, avec N = 11 et m = 3, caractérisé,

par le fait que la pondération du 1er signal de différence se fait avec h(5), celle du 2ème, avec -h(3), celle du 3ème avec h(1), et que h(0) = -1/2 et

par le fait que la somme des signaux de différence donne la partie réelle $s_r(2kT)$ et que le signal pondéré avec h(0) donne la partie imaginaire $s_i(2kT)$ (figure 4).

6. Filtre demi-bande non récursif selon la revendication 3, avec N = 11 et m = 0, caractérisé

par le fait que la pondération du 1er signal de différence se fait avec h(5), celle du 2ème avec -h(3) et celle du 3ème avec h(1) et

par le fait que la somme des signaux de différence donne la partie imaginaire $s_i(2kT)$ et que le signal pondéré avec h(0) = 1/2 donne la partie réelle $s_r(2kT)$ (figure 3).

7. Filtre demi-bande non récursif selon la revendication 3, avec N = 11 et m = 0, caractérisé

par le fait que la pondération du 1er signal de différence se fait avec -h(5), celle du 2ème avec h(3) et celle du 3ème avec -h(1) et

par le fait que la somme des signaux de différence donne la partie imaginaire $s_i(2kT)$ et que le signal pondéré avec h(0) = -1/2 donne la partie réelle $s_r(2kT)$ (figure 3).

**8.** Filtre demi-bande non récursif selon la revendication 3, caractérisé,

par le fait qu'il est prévu une chaîne de (N-1)/2 éléments retardateurs du temps de retardement 2T, par le fait que l'on amène au premier élément retardateur de cette chaîne la partie réelle $s_r(2kT)$, pondérée avec une valeur $h(1)$ de la réponse impulsionnelle et que l'on soustrait du signal de sortie du dernier élément retardateur de cette chaîne cette partie réelle, signal de différence qui fournit une sur deux des valeurs d'échantillonnage du signal de sortie réel du filtre $s(kT)$,

par le fait qu'au signal transversal de cette chaîne d'éléments retardateurs, aux autres points, on ajoute en outre les valeurs instantanées, pondérées par une valeur $h(1)$ de la réponse impulsionnelle, de la partie réelle $s_r(2kT)$ du signal d'entrée du filte,

par le fait qu'il est prévu un autre élément retardateur du temps de retardement $T.(N-3)/2$ à l'entrée duquel on amène la partie imaginaire $s_i(2kT)$ pondérée par $h(0)$ et dont la sortie fournit une sur deux, décalée dans le temps, des valeurs d'échantillonnage du signal de sortie réel du filtre $s(kT)$.

**9.** Filtre demi-bande non récursif selon la revendication 8, avec $m = 0$ et $N = 11$, caractérisé,

par le fait que la pondération des valeurs instantanées, amenées, de la partie réelle $s_r(2kT)$ du signal d'entrée du filtre se fait comme suit:

à l'entrée du 1er élément retardateur $h(5)$,
à l'entrée du 2ème élément retardateur $-h(3)$,
à l'entrée du 3ème élément retardateur $h(1)$,
à l'entrée du 4ème élément retardateur $-h(1)$,
à l'entrée du 5ème élément retardateur $h(3)$ et
à la sortie du 5ème élément retardateur $-h(5)$ et
par le fait que $h(0) = 1/2$ (figure 6).

**10.** Filtre demi-bande non récursif dont on convertit le signal d'entrée réel $s(kT)$, en conservant la fréquence d'échantillonnage $fA = 1/T$, en un signal de sortie complexe $\underline{s}(kT)$ avec $k$ comme indice courant, étant précisé que l'on module sa réponse impulsionnelle $h(1)$, pour $1 = -(N-1)/2$ à $(N-1)/2$ et pour la longueur impaire $N$ du filtre, sur la porteuse complexe d'une fréquence de $\pm 1/4$ de la fréquence d'échantillonnage $f.4 = 1/T$ pour obtenir:

$$\underline{h}(l) = h(l) \cdot e^{j(\pm 2\pi l fA/4fA) + \varphi 0} = j^{\pm l} \cdot e^{j\varphi 0} \cdot h(l)$$

et étant précisé que la phase zéro degré $\varphi 0$ de cette fréquence se présente pour tous les multiples $m$ de $\pi/2$ avec $m = 0, 1, 2, 3....$, étant précisé que l'on forme chaque fois des signaux de différence; signal de sortie du dernier élément retardateur moins signal d'entrée du 1er élément retardateur = 1er signal de différence, signal de sortie du pénultième élément retardateur moins signal d'entrée du 2ème élément retardateur = 2ème signal de différence, signal de sortie de l'antépénultième élément retardateur moins signal d'entrée du 3ème élément retardateur = 3ème signal de différence etc, étant précisé que l'on soumet ces signaux de différences à une pondération (multiplication) par une valeur $h(1)$ de la réponse impulsionnelle et qu'ensuite on les additionne et que l'on obtient soit la partie réelle, soit la partie imaginaire du signal de sortie du filtre $\underline{s}(kT)$, filtre caractérisé

par le fait que l'on conserve la fréquence d'échantillonnage $fA = 1/T$,

par le fait que l'on amène chaque valeur d'échantillonnage du signal d'entrée $s(kT)$ dans une chaîne de (N-1)/2 éléments retardateurs de temps retardateur 2T, étant précisé que l'élément retardateur médian est divisé en deux éléments de temps retardateur $T$,

et par le fait qu'à partir du milieu de la chaîne on pondère avec la valeur $h(0)$ le signal d'entrée retardé du temps retardateur $T \cdot (N - 1)/2$, ce qui donne la partie imaginaire ou la partie réelle du signal de sortie du filtre $\underline{s}(kT)$.

**11.** Filtre demi-bande non récursif dont on convertit le signal d'entrée complexe $\underline{s}(kT)$, avec $k$ comme indice courant, en un signal de sortie réel $s(kt)$, par le moyen que l'on module sa réponse impulsionnelle $h(1)$, rapportée à la fréquence d'échantillonnage $fA$, pour $1 = -(N-1)/2$ à $(N-1)/2$ et pour la longueur impaire $N$ du filtre, sur la porteuse complexe d'une fréquence $\pm fA/4$, pour obtenir:

$$\underline{h}(l) = h(l) \cdot e^{j(\pm 2\pi l fA/4fA) + \varphi 0} = j^{\pm l} \cdot e^{j\varphi 0} \cdot h(l)$$

et étant précisé que la phase zéro degré $\varphi 0$ de cette fréquence se présente pour tous les multiples $m$ de $\pi/2$ ($0 = m/2$ avec $m = 0, 1, 2, 3 ...$), étant précisé que l'on amène la partie imaginaire $s_i(kT)$, pondérée avec une valeur $h(1)$ de la réponse impulsionnelle, au 1er élément retardateur de cette chaîne et qu'on la soustrait du signal de sortie du dernier élément retardateur de cette chaîne, signal de différence qui fournit le signal de sortie réel $s(kT)$ du filtre, étant précisé qu'au signal transversal de cette chaîne d'éléments retardateurs, aux autres points, on ajoute des valeurs instantanées supplémentaires, pondérées avec une valeur h(1) de la réponse impulsionnelle, de la partie imaginaire $s_i$(kT) du signal d'entrée du filtre, filtre caractérisé

par le fait que l'on conserve la fréquence d'échantillonnage fA = 1/T,

par le fait qu'il est prévu une chaîne de (N-1)/2 éléments retardateurs de temps de retardement 2T, étant précisé que l'élément retardateur médian est divisé en deux éléments de temps de retardement T,

et par le fait qu'au milieu de la chaîne de retardement on introduit, en plus du signal transversal de la chaîne, la partie réelle $s_r$(kT) du signal d'entrée complexe du filtre, valorisée par h(0).

**12.** Filtre demi-bande non récursif selon la revendication 10, avec N = 11 et m = 1, caractérisé,

par le fait que l'on pondère le 1er signal de différence avec -h(5), le 2ème signal de différence avec h(3) et le 3ème signal de différence avec -h(1) et que h(0) = 1/2 et

par le fait que la somme des signaux de différence donne la partie réelle $s_r$(kT) et que le signal, pondéré avec h(0), donne la partie imaginaire $s_i$(kT) (figure 14).

**13.** Filtre demi-bande non récurcif selon la revendication 10, avec N = 11 et m = 3, caractérisé,

par le fait que la pondération du premier signal de différence se fait avec h(5), celle du 2ème avec -h(3), celle du 3ème avec h(1) et que h(0) = -1/2 et par le fait que la somme des singaux de différence donne la partie réelle $s_r$(kT) et que le signal pondéré avec h(0) donne la partie imaginaire $s_i$(kT) (figure 14).

**14.** Filtre demi-bande non récursif selon la revendication 10 avec N = 11 et m = 0, caractérisé,

par le fait que la pondération du 1er signal de différence se fait avec h(5), celle du 2ème signal de différence, avec -h(3) et celle du 3ème signal avec h(1) et

par le fait que la somme des signaux de différence donne la partie imaginaire $s_i$(kT) et que le signal pondéré avec h(0) = 1/2, donne la partie réelle $s_r$(kT) (figure 13).

**15.** Filtre demi-bande non récursif selon la revendication 10, avec N = 11 et m = 2, caractérisé,

par le fait que la pondération du 1er signal de différence se fait avec -h(5), celle du 2ème signal de différence, avec h(3), celle du 3ème signal de différence, avec -h(1), et

par le fait que la somme des signaux de différence donne la partie imaginaire $s_i$(kT) et que le signal pondéré avec h(0) = -1/2 donne la partie réelle $s_r$ (figure 13).

**16.** Filtre demi-bande non récursif selon la revendication 11, avec m = 0 ou 2 et N = 11, caractérisé,

par le fait que la pondération des valeurs instantanées, amenées, de la partie réelle $s_r$(kT) ou de la partie imaginaire $s_i$(kT) du signal d'entrée du filtre se fait comme suit:

à l'entrée du 1er élément retardateur ±h(5),

à l'entrée du 2ème élément retardateur ±h(3),

à l'entrée du 3ème élément retardateur ±h(1),

à l'entrée du pénultième élément retardateur ±h(1),

à l'entrée du dernier élément retardateur ±h(3) et

à la sortie du dernier élément retardateur ±h(5) et

par le fait que h(0) = ±1/2 (figure 16).

EP 0 339 037 B1

Halbband-Filter (Prototyp)

FIG. 2

FIG 1

$T = 1/f_A$

FIG. 5

14

FIG. 3

(m=0;2 ; N=11)

m = 1  und  m = 3     für N = 11

$\downarrow$ 2 Verminderung

FIG. 4

( m = 1; 3; N = 11 )

FIG. 6 (m=0;2; N=11)

FIG. 7

( m = 1;3 ; N = 11 )

FIG. 8, FIG. 9, FIG. 10 entfallen

Halbband-Filter (Prototyp)

FIG.12

FIG.11    $s(kT)$    DF    $\underline{s}(.kT)$

$T=1/f_A$

FIG.15    $\underline{s}(.kT)$    _DF    $s(kT)$

FIG.13

$(m=0;2\;;\;N=11)$

m = 1 und m = 3 für N = 11

$s(kT)$

$\mp h(5)$    $\pm h(3)$    $\mp h(1)$

$s_r ( kT)$

$s_i ( kT)$    $\underline{s} ( kT)$

$h(o) = \pm \frac{1}{2}$

# FIG.14

$( m = 1;3; N = 11 )$

FIG.16 (m=0;2; N=11)

$$h(0)=\pm\frac{1}{2}$$

FIG.17

( m = 1;3 ; N=11 )